# EUROPÄISCHE PATENTSCHRIFT

(11) **EP 2 697 618 B1**
(45) Veröffentlichungstag und Bekanntmachung des Hinweises auf die Patenterteilung: **24.06.2015**
(21) Anmeldenummer: 11749792.5
(22) Anmeldetag: 18.08.2011
(51) Int. Cl.: G01L 3/10, G01R 33/09, H01L 41/20, H01L 43/10

(54) **VORRICHTUNG ZUM ERMITTELN EINES DREHMOMENTS UND ZUGEHÖRIGES MESSVERFAHREN**
DEVICE FOR DETERMINING A TORQUE AND ASSOCIATED MEASURING METHOD
DISPOSITIF POUR DÉTERMINER UN COUPLE ET PROCÉDÉ DE MESURE CORRESPONDANT

(43) Veröffentlichungstag der Anmeldung: 19.02.2014
(73) Patentinhaber: Siemens Aktiengesellschaft, 80333 München (DE)
(72) Erfinder: HASSEL, Jörg, 91058 Erlangen (DE); RIEGER, Gotthard, 80636 München (DE); WEISS, Roland, 91058 Erlangen (DE); WIEGAND, Hermann-Josef, 36169 Rasdorf (DE)
(86) Internationale Anmeldenummer: PCT/EP2011/064227
(87) Internationale Veröffentlichungsnummer: WO 2013/023699

(56) Entgegenhaltungen:
- EP-A2- 1 167 936
- DE-A1-102006 019 482
- DE-A1-102007 003 382
- JP-A- 5 340 826

## Beschreibung

Die Erfindung betrifft eine Vorrichtung zum Ermitteln eines Drehmoments, welches auf eine Antriebswelle wirkt. Bei der Antriebswelle kann es sich beispielsweise um eine Welle zwischen einem Motor und einer Arbeitsmaschinen handeln, über welche ein Drehmoment des Motors zur Antriebsmaschine übertragen wird. Die Erfindung betrifft auch ein Verfahren zum Ermitteln des Drehmoments.

Die Erfassung eines Drehmoments an einer Welle oder an einer Kupplung für eine solche Welle findet in der industriellen Antriebstechnik, in der Energietechnik, bei Bahnantrieben und in der Automobiltechnik Anwendung. Bei einer Ausprägung von Drehmomentsensoren erfolgt das Ermitteln des Drehmoments berührungslos. Hierbei wird ein mit einer Richtung oder einem Betrag des Drehmoments korreliertes Signal von den rotierenden Teilen (Welle oder Kupplung) an einen ortsfesten Sensor, beispielsweise über einen Luftspalt, hinweg übermittelt. So müssen keine Verschleißteile, wie zum Beispiel Schleifkontakte, verwendet werden. Dies erhöht die Zuverlässigkeit der Sensoren erheblich.

Ein mit dem übertragenen Drehmoment korreliertes Signal kann mittels einer magnetischen Einrichtung erzeugt werden, welche auf der Welle befestigt ist und welche ein magnetisches Feld erzeugt. Dieses Magnetfeld wird von einem ortsfest in der Nähe der Welle angeordneten Magnetfeldsensor gemessen und von einer geeigneten Elektronik weiterverarbeitet. Als Magnetfeldsensoren werden Hall-Sensoren oder Sensoren verwendet, die auf dem AMR-Effekt (Anisotroper magnetoresistiver Effekt) beruhen. Nachteilig bei einem magnetfeldbasierten Drehmomentsensor ist, dass die verwendeten Magnetfeldsensoren auch bei einem konstanten Drehmoment stark schwankende Signale erzeugen. Daher ist ein verhältnismäßig großer Schaltungsaufwand nötig, um ein Drehmoment mit einem magnetfeldbasierten Drehmomentsensor zuverlässig zu ermitteln.

In der EP 1 167 936 A2 ist eine Vorrichtung zum Ermitteln eines auf einer Antriebswelle wirkenden Drehmoments beschrieben, welche zwei auf der Welle angeordnete Kränze aus jeweils mehreren Permanentmagneten und neben der Welle angeordnete magnetoresistive Halbleiterelemente als Magnetsensoren aufweist. Bei einer Rotation der Welle werden die Magneten jedes Kranzes an jeweils einem der Magnetfeldsensoren vorbeibewegt, sodass dieser als ein Ausgangssignal jeweils ein Sägezahnsignal erzeugen. Die beiden Kränze sind auf der Welle über einen Torsionsstab gekoppelt. Wirkt auf die Welle ein Drehmoment, so verdrehen sich die beiden Kränze gegeneinander, was sich in Ausgangssignalen der Magnetfeldsensoren als eine Phasenverschiebung eines der Signale gegenüber dem Signal des anderen Magnetfeldsensors erkennen lässt.

In der DE 10 2007 003382 A1 ist ein Sensor beschrieben, der mechanisch flexibel ausgestaltet und als Hohlzylinder um eine Welle angeordnet sein kann. Der Sensor kann ein organisches, magnetisch resistives Element umfassen. Mit dem Sensor kann eine Drehzahl der Welle beispielsweise eines Elektromotors gemessen werden, wozu die Welle dann magnetisch ausgeführt ist. Die Messvorrichtung ist dazu vorgesehen, anhand des Signals des Sensors beispielsweise Risse in der Welle zu erkennen.

Aus der DE 10 2006 019482 A1 ist ein organisches Elektronikbauteil beschrieben, welches als OMR wirkendes Halbleiterelement ausgestaltet sein kann. Es kann beispielsweise zum Messen eines Magnetfelds in einem Kompass verwendet werden. Das OMR-Halbleiterelement kann eine zusätzliche Schicht aufweisen, die selbstemittierend ist.

In der JP 5 34 0826 A ist die Verwendung des inversen magnetostriktiven Effekts zum Aufbau einer magnetischen Felderzeugungseinrichtung eines Drehmomentmesselements beschrieben.

Es ist Aufgabe der vorliegenden Erfindung, ein Drehmoment an einer Antriebswelle oder an einer Kupplung derselben zu ermitteln.

Die Aufgabe wird durch eine Vorrichtung gemäß Patentanspruch 1 und durch ein Verfahren gemäß Patentanspruch 10 gelöst. Vorteilhafte Weiterbildungen der erfindungsgemäßen Vorrichtung sind durch die Unteransprüche gegeben.

Bei der erfindungsgemäßen Vorrichtung wird ein organisches, magnetoresistives Halbleiterelement (OMR-Halbleiterelement) verwendet, um das Drehmoment an einer Antriebswelle oder an der Kupplung berührungslos zu ermitteln. Ein OMR-Halbleiterelement basiert auf einem organischen Halbleiter und verändert seinen elektrischen Widerstand in Abhängigkeit von einem magnetischen Feld, wenn dieses das OMR-Halbleiterelement durchdringt.

Zum Erfassen des Drehmoments weist die erfindungsgemäße Vorrichtung dabei eine mit der Antriebswelle oder einer Kupplung derselben fest verbundene Felderzeugungseinrichtung auf, welche in einer Umgebung der Antriebswelle ein magnetisches Feld erzeugt, das von dem Drehmoment (seiner Richtung und/oder seinem Betrag) abhängig ist. In der Umgebung, in welcher das Feld erzeugt wird, ist das OMR-Halbleiterelement ortsfest angeordnet. Das OMR-Halbleiterelement weist zwei Elektroden auf, zwischen denen eine Spannungsquelle der erfindungsgemäßen Vorrichtung einen elektrischen Strom oder eine elektrische Spannung erzeugt.

Mit der erfindungsgemäßen Vorrichtung lässt sich das Drehmoment in folgender Weise gemäß dem erfindungsgemäßen Verfahren ermitteln. Durch die Felderzeugungseinrichtung wird auf der Antriebswelle (oder gegebenenfalls auf der Kupplung) ein magnetisches Feld in Abhängigkeit von dem Drehmoment erzeugt. Dieses Feld wird in der Umgebung der Antriebswelle mittels des OMR-Halbleiterelements erfasst. Hierdurch wird es ermöglicht, mittels des OMR-Halbleiterelements eine elektrische Größe in Abhängigkeit von dem erfassten magnetischen Feld einzustellen. Bei dieser elektrischen Größe kann es sich beispielsweise um einen zwischen den Elektroden fließenden Strom handeln. Bevorzugt wird durch die Spannungsquelle eine strom-oder spannungskonstante Messung ermöglicht.

Die erfindungsgemäße Vorrichtung und das erfindungsgemäße Verfahren weisen den Vorteil auf, dass ein mit ihnen ermitteltes Messsignal für das Drehmoment nur verhältnismäßig geringe Schwankungen aufweist, die nicht von einer Drehmomentänderung hervorgerufen werden. Zudem lässt sich auf ihrer Grundlage ein Drehmomentsensor mit geringem Aufwand und niedrigen Kosten herstellen.

Gemäß der erfindungsgemäßen Vorrichtung ist durch das OMR-Halbleiterelement eine OLED gebildet, das heißt eine organische Leuchtdiode (OLED - organic light emitting diode). Dies ist durch eine entsprechende Wahl des für die Herstellung des OMR-Halbleiterelements verwendeten organischen Halbleitermaterials erreichbar. Mittels einer OLED wird auf eine einfach zu realisierende Weise eine visuelle Darstellung des von der Welle übertragenen Drehmoments ermöglicht. Beispielsweise kann erreicht werden, dass ein Bereich der Welle, in welchem ein großes Drehmoment wirkt, heller erscheint als ein weniger belasteter Bereich.

Das OMR-Halbleiterelement kann als Schicht ausgebildet sein, welche die Antriebswelle und/oder die Kupplung zumindest bereichsweise umgibt. Hierdurch wird das magnetische Feld mittels des OMR-Halbleiterelements im Vergleich zu einer Erfassung mit einem Hall-Sensor oder einem AMR-Sensor nicht quasipunktförmig, sondern verhältnismäßig großflächig erfasst.

Daraus ergeben sich bei der Messung des Drehmoments Mittelungseffekte, welche für ein schwankungsarmes Messsignal sorgen. Eine bevorzugte Ausführungsform der erfindungsgemäßen Vorrichtung weist ein OMR-Halbleiterelement auf, das die Form eines Hohlzylinders aufweist. Dieses hohlzylindrische OMR-Halbleiterelement umgibt dabei die Antriebswelle in Umfangsrichtung der Antriebswelle, so dass eine Schwankung des Messsignals, wie sie durch eine Rotation der Antriebswelle verursacht werden könnte, wirkungsvoll unterdrückt ist. Als ebenfalls günstig kann sich ein OMR-Halbleiterelement in Form eines Segments eines Hohlzylinders erwiesen, da sich dieses (beispielsweise zu Reparaturzwecken) mit geringem Aufwand aus der Umgebung der Antriebswelle entfernen lässt. Es lässt sich zudem auch z.B. als Wellenschutz ausführen.

Ein weiterer Vorteil ergibt sich, wenn das OMR-Halbleiterelement auf einem flexiblen Substrat angeordnet ist. Dies lässt eine sehr einfache, platzsparende Konstruktion eines Gehäuses der Vorrichtung zu und ermöglicht eine einfache, kostengünstige Montage der Drehmomentensensorik.

Eine andere Weiterbildung der erfindungsgemäßen Vorrichtung sieht eine Messeinrichtung zum Messen einer Größe vor, die zu einem durch das OMR-Halbleiterelement fließenden Strom und/oder einer an dem OMR-Halbleiterelement anliegenden Spahnung proportional ist. Diese Größe können beispielsweise der Strom bzw. die Spannung selber sein oder eine elektrische Spannung, die über einem weiteren Element abfällt, das von demselben Strom durchflossen wird wie das OMR-Halbleiterelement. Auf der Grundlage eines Messsignals für die Größe lässt sich in vorteilhafter Weise eine automatisierte Überwachung des Drehmoments bereitstellen oder ein Steuersignal für eine Anzeige bilden.

Ein besonders guter Messeffekt für das Drehmoment ergibt sich, wenn das OMR-Halbleiterelement mit einer konstanten Spannung innerhalb eines Betriebsbereichs betrieben wird, in welchem das OMR-Halbleiterelement eine maximale Feldempfindlichkeit aufweist. Entsprechend sieht eine vorteilhafte Weiterbildung der erfindungsgemäßen Vorrichtung vor, dass die Spannungsquelle als Konstantspannungsquelle ausgelegt ist. Die Feldempfindlichkeit gibt hierbei die Änderung dR des elektrischen Widerstands des OMR-Halbleiterelement bezogen auf eine Änderung der magnetischen Feldstärke dH an, also dR/dH.

Eine andere vorteilhafte Art einer optischen Drehmomentanzeige ist gegeben, wenn die elektrische Spannung, die zwischen den Elektroden der OLED erzeugt wird, auf einen Wert eingestellt ist, bei welchem.die OLED nur leuchtet, falls das Drehmoment ein vorbestimmtes Kriterium erfüllt. So lässt sich durch entsprechende Vorgabe des Kriteriums beispielsweise anzeigen, ob ein bestimmtes minimales Drehmoment übertragen wird oder ob etwa ein maximal zulässiges Drehmoment überschritten ist.

Bei einer anderen vorteilhaften Weiterbildung der erfindungsgemäßen Vorrichtung weist diese wenigstens zwei OMR-Halbleiterelemente auf, die jeweils in einer der bereits beschriebenen Weise ausgestaltet sind. Bei dieser Weiterbildung können die OMR-Halbleiterelemente unterschiedliche Kennlinien aufweisen, so dass sie unterschiedliche magneto-resistive Eigenschaften aufweisen. Zusätzlich oder alternativ dazu werden zwischen den jeweiligen Elektroden der OMR-Halbleiterelemente in einem Betrieb der Vorrichtung unterschiedlich große elektrische Spannungen erzeugt. Durch Bereitstellen von mehreren OMR-Halbleiterelementen ergibt sich der Vorteil, dass die maximale Feldempfindlichkeit bei jedem OMR-Halbleiterelement für eine andere absolute magnetische Feldstärke gegeben sein kann. Dies ermöglicht eine genaue Messung des Drehmoments über einen größeren Drehmomentbereich hinweg.

Im Zusammenhang mit der Bereitstellung mehrerer OMR-Halbleiterelemente, die jeweils auch eine OLED bilden, ergibt sich ein weiterer Vorteil, wenn die OLEDs in Bezug auf das Drehmoment unterschiedliche Leuchtgrenzen aufweisen. Unter einer Leuchtgrenze ist hierbei diejenige magnetische Feldstärke zu verstehen, bei deren Überschreiten die jeweilige OLED leuchtet. Mittels einer solchen Anordnung lassen sich Grenzen für Drehmomentbereiche vorgeben. Zu den einzelnen Drehmomentbereichen wird dann von den entsprechend leuchtenden OLEDs angezeigt, in welchem davon sich ein aktuelles Drehmoment gerade befindet. Durch eine entsprechend hohe Anzahl von OLEDs kann sogar eine nahezu kontinuierliche visuelle Anzeige des Drehmoments an der Antriebswelle oder der Kupplung bereitgestellt werden.

Im Zusammenhang mit einer Erzeugung des magnetischen Feld auf der Antriebswelle bzw. Kupplung sieht eine Ausführungsform der erfindungsgemäßen Vorrichtung vor, dass die Felderzeugungseinrichtung zwei magnetische Elemente aufweist, deren relative Lage zueinander von dem Drehmoment abhängig ist. Hierbei ist denkbar, dass ein Magnet als ein erstes magnetisches Element von einem zweiten, weichmagnetischen Element abgedeckt ist, welches den Magneten zur Umgebung der Antriebswelle hin abschirmt. Durch einen entsprechenden Mechanismus lässt sich dann das weichmagnetische Element in Abhängigkeit von dem Drehmoment verschieben, so dass dann ein Teil des Felds des Magneten in die Umgebung gelangt.

Eine bevorzugte Ausführungsform der erfindungsgemäßen Vorrichtung sieht vor, dass die Felderzeugungseinrichtung ein Element umfasst, welches das magnetische Feld durch inverse Magnetostriktion in Abhängigkeit von einer Veränderung seiner Form erzeugt, die von dem Drehmoment verursacht wird. Diese Ausführungsform weist den Vorteil auf, dass keine störanfällige mechanische Anordnung zum Erzeugen eines veränderbaren Magnetfelds benötigt wird.

Im Zusammenhang mit dem erfindungsgemäßen Verfahren gehören zu der Erfindung auch Weiterbildungen, die den Weiterbildungen der erfindungsgemäßen Vorrichtung entsprechen. Sie sind hier deshalb nicht gesondert beschrieben.

Die Erfindung wird im folgenden anhand von Ausführungsbeispielen beschrieben. Dazu zeigt:
- FIG 1: eine schematische Darstellung eines Drehmomentsensors gemäß einer Ausführungsform der erfindungsgemäßen Vorrichtung,
- FIG 2: einen prinzipiellen Verlauf von Kennlinien eines OMR-Sensors bzw. einer OLED und
- FIG 3: eine schematische Darstellung eines Drehmomentsensors gemäß einer weiteren Ausführungsform der erfindungsgemäßen Vorrichtung.

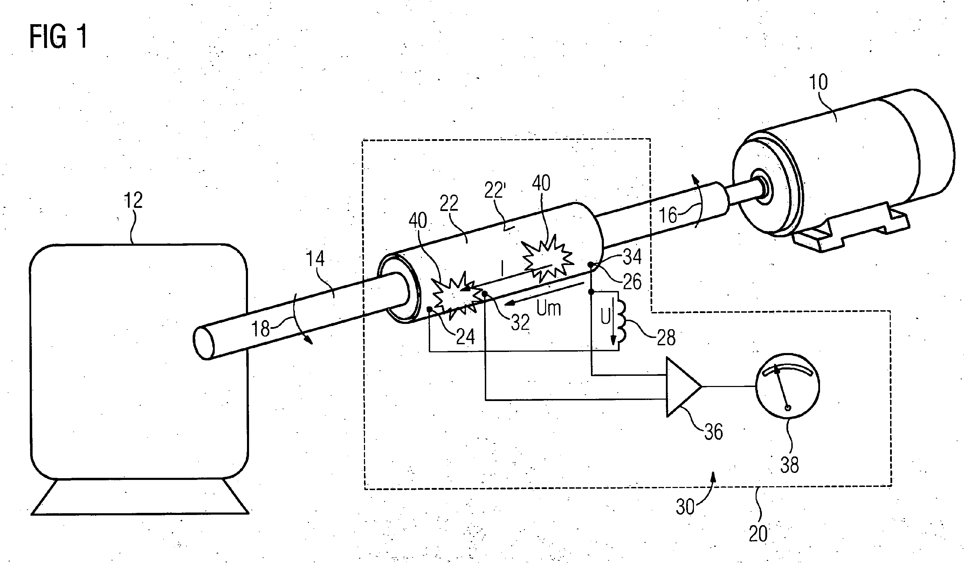

In FIG 1 sind ein Motor 10 und eine Arbeitsmaschine 12 gezeigt. Bei der Arbeitsmaschine 12 kann es sich beispielsweise um eine Fräsmaschine oder ein Förderband handeln. Die Arbeitsmaschine 12 wird von dem Motor 10 angetrieben. Dazu ist der Motor 10 mit der Arbeitsmaschine 12 über eine Welle 14 gekoppelt, über die der Motor 10 ein Motordrehmoment 16 zu einer (nicht näher dargestellten) Kupplung der Arbeitsmaschine 12 überträgt. Die Welle 14 rotiert dabei um ihre Längsachse. An der Kupplung wirkt auf die Welle 14 ein Lastmoment 18 der Arbeitsmaschine 12.

Während eines Betriebs der Arbeitsmaschine 12 soll ermittelt werden, wie groß das von dem Motor 10 über die Welle 14 zur Arbeitsmaschine 12 übertragene Drehmoment ist. Dazu wird eine auf die Welle 14 wirkende Torsionskraft mit einem Drehmomentsensor 20 an der Welle 14 gemessen. Die Törsionskraft ergibt sich aus dem Motordrehmoment 16 und dem diesem entgegenwirkenden Lastmoment 18. Aus der ermittelten Torsionskraft kann auf das übertragene Drehmoment rückgeschlossen werden.

Der Drehmomentsensor 20 ist eine Ausführungsform der erfindungsgemäßen Vorrichtung. Die Messung erfolgt berührungslos. Dazu ist die Welle 14 konzentrisch in einer Hülse 22 angeordnet. Die Hülse 22 berührt die Welle 14 nicht, so dass die Welle 14 in der Hülse 22 rotieren kann. Die Hülse 22 ist fest mit einem (nicht dargestellten) Boden verbunden und rotiert nicht mit der Welle 14 mit.

Die Hülse 22 weist eine Schicht 22' aus einem organischen Halbleitermaterial auf, bei dem ein elektrischer Widerstand von einer Feldstärke eines das Halbleitermaterial durchdringenden magnetischen Felds abhängt (magnetoresistiver Effekt). Das magnetische Feld wird von einer magnetischen Beschichtung erzeugt, die Bestandteil der Welle 14 ist und die sich im Bereich der Hülse 22 auf oder in einem stählernen Stab der Welle 14 befindet. Die Beschichtung ist so fest mit dem Stab verbunden, dass sich ihre Form zusammen mit derjenigen des Stabes verändert, wenn auf diesen die zu messende Torsionskraft wirkt. Die magnetische Beschichtung umfasst ein magnetisches Material, welches um die Welle 14 herum oder an den Enden der Beschichtung ein magnetisches Streufeld erzeugt, dessen Feldstärke von der Form eines durch die Beschichtung gebildeten Körpers abhängt (inverse Magnetostriktion). Dieses magnetische Feld durchdringt die Hülse 22. Eine Feldstärke des magnetischen Feldes ist umso größer, je größer die Torsionskraft ist, welche auf die Welle 14 wirkt.

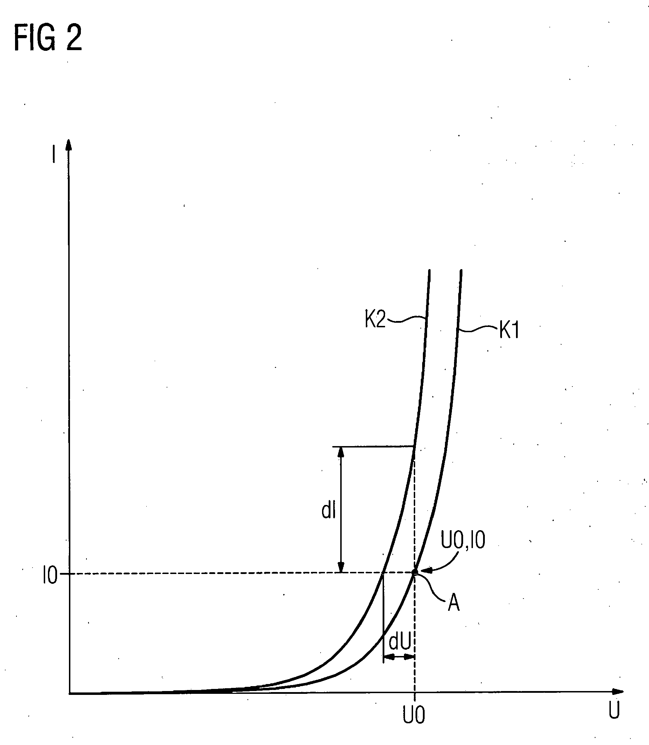

Anhand von FIG 1 und FIG 2 ist im Folgenden erläutert, die das über die Welle 14 übertragene Drehmoment, das heißt die auf die Welle 14 wirkende Torsionskraft, ermittelt wird.

Die auf der Hülse 22 befindliche Schicht 22' aus dem organischen Halbleitermaterial ist über zwei Elektroden 24, 26 mit einer Spannungsquelle 28 elektrisch verbunden. Die Spannungsquelle 28 erzeugt zwischen den Elektroden 24, 26 eine elektrische Spannung U mit dem Spannungswert U0. Für den Fall, dass keine Torsionskraft auf die Welle 14 wirkt, fließt hierdurch durch die Schicht 22' ein elektrischer Strom I mit der Stromstärke I0. Dies entspricht einem Arbeitpunkt A auf einer U/1-Kennlinie K1 des organischen Halbleitermaterials. Eine Kennlinie K2 ergibt sich, wenn das organische Halbleitermaterial von einem magnetischen Feld mit einer bestimmten, größeren Feldstärke durchdrungen wird. Hierdurch steigt für den Fall, dass die Spannungsquelle 28 eine konstante Spannung U mit dem Spannungswert U0 erzeugt, der Strom I um einen Stromstärkewert dI. Wird durch die Spannungsquelle 28 dagegen ein konstanter Strom I mit der Stromstärke I0 erzeugt, so verringert sich die Spannung U um einen Spannungswert dU.

Wird als Spannungsquelle 28 eine Konstantspannungsquelle verwendet, ist es möglich, zur quantitativen Messung des Magnetfelds eine Stromerhöhung dI von ca. zehn bis dreißig Prozent bezogen auf I0 mittels der in FIG 1 gezeigten Anordnung zu erhalten. Dies ermöglicht eine sehr genaue Messung der Änderung der magnetischen Feldstärke.

Mittels einer Messschaltung 30 wird zwischen zwei Messelektroden 32, 34 der Messschaltung 30 eine Spannung Um an der Schicht 22' gemessen. Die Spannung Um wird von dem Strom I hervorgerufen. Die gemessene Spannung Um wird von einem Verstärker 36 der Messschaltung 30 elektronisch verstärkt. Das so verstärkte Signal wird an eine Anzeigeeinrichtung 38 der Messschaltung 30 übertragen, die auf Grundlage des Signals die auf die Welle 14 wirkende Torsionskraft und damit das über die Welle 14 übertragene Drehmoment ermittelt und anzeigt. Die Werte der Spannung Um und damit auch das verstärkte Signal weisen bei einem konstanten Drehmoment nur geringfügige Schwankungen auf. Indem die Hülse 22 und damit auch die Schicht 22' die Welle 14 in Umfangsrichtung vollständig umgibt, wirkt sich eine Asymmetrie des Magnetfelds, welche wegen der Rotation der Welle 14 eine periodisch schwankende Feldstärke in jedem Punkt der Hülse 22 erzeugt, durch einen Mittelungseffekt in der Schicht 22' nicht auf die Spannung Um aus. Bei einem Hall-Sensor, der sich nicht so flächig ausgestalten lässt wie das organische Halbleiterelement und der deshalb das magnetische Feld nur punktuell erfasst, würde die Rotation der Welle 14 ein schwankendes Signal verursachen.

Der Strom I und die Spannung Um sind elektrische Größen, die durch den magnetoresistiven Effekt von der Schicht 22' in Abhängigkeit von dem magnetischen Feld verändert werden. Anstelle der Spannung Um kann durch die Messschaltung 30 auch ein Messstrom gemessen werden.

Das organische Halbleitermaterial der Schicht 22' stellt eine OLED dar, welche leuchtet, wenn die Stromstärke des durch sie fließenden Stromes I einen bestimmten Stromstärkewert überschreitet. Die Spannung U der Spannungsquelle 28 ist in der Weise eingestellt, dass der Leuchteffekt dann einsetzt, wenn das auf die Welle 14 wirkende Drehmoment größer als ein maximal zulässiges Drehmoment ist. Hierdurch wird einer Bedienperson der Arbeitsmaschine 12 dann unmittelbar durch luminiszierende Bereiche 40 der Schicht 22' angezeigt, dass der Motor 12, die Arbeitsmaschine 12 oder die Welle 14 überlastet ist.

Zum Bilden der Schicht 22' wurde das organische Halbleitermaterial auf ein flexibles Substrat aufgetragen. Dabei kann es sich beispielsweise um Polyethylen (PET) oder um ein Polyimide handeln, wie es etwa unter der Bezeichnung Kepton erhältlich ist.

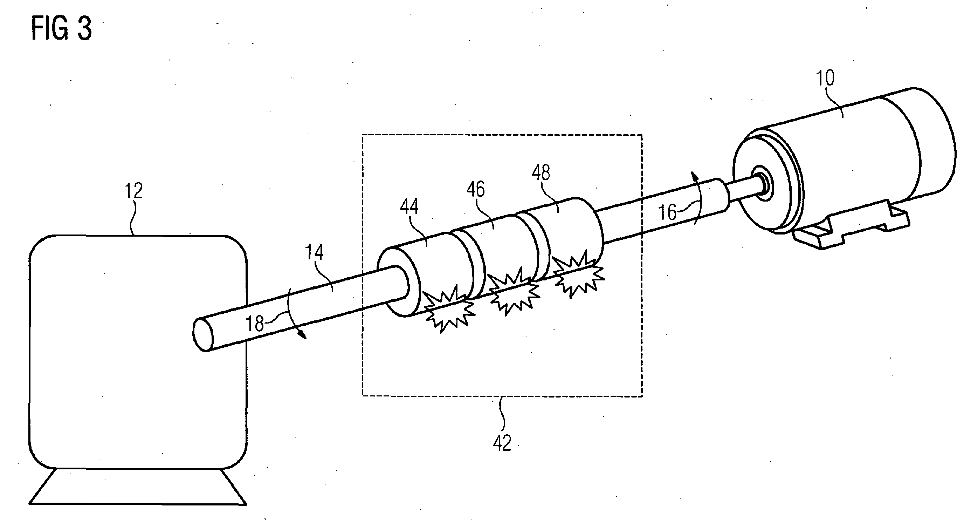

In FIG 3 ist eine weitere Anordnung aus einem Motor 10, einer Arbeitsmaschine 12 und einer Welle 14 gezeigt. In FIG 3 sind Elemente, die in ihrer Funktionsweise in FIG 1 gezeigten Elementen entsprechen, mit gleichen Bezugszeichen versehen wie in FIG 1.

Ein Drehmomentsensor 42 weist bei dem in FIG 3 gezeigten Beispiel drei Ringe 44, 46, 48 auf, von denen jeder eine Schicht aus einem organischen Halbleitermaterial aufweist, durch welches eine OLED gebildet ist. Der Drehmomentsensor 42 ist eine Ausführungsform der erfindungsgemäßen Vorrichtung. In jeder der drei Schichten fließt ein Strom, der durch eine (nicht dargestellte) Spannungsquelle in ähnlicher Weise erzeugt wird, wie es im Zusammenhang mit FIG 1 bereits erläutert wurde. Die drei Ringe 44, 46, 48 sind von einem Magnetfeld durchdrungen, dass von der Welle 14 in der bereits beschriebenen Weise erzeugt wird.

Jeder der Ringe 44, 46, 48 weist eine andere Leuchtegrenze auf: Wird über die Welle 14 ein Drehmoment übertragen, dass größer als ein vorbestimmtes minimales Drehmoment ist, so leuchtet der Ring 48, während die übrigen Ringe 44, 46 zunächst dunkel bleiben. Erst wenn das Drehmoment eine untere Grenze eines Normal- oder auch Arbeitsdrehmomentbereichs überschreitet, leuchtet auch der Ring 46. Wenn ein vorbestimmtes maximal zulässiges oder auch Überlast-Drehmoment überschritten ist, leuchtet auch der Ring 44. Wird das Überlast-Drehmoment durch Lastsprünge wiederholt und nur kurzzeitig überschritten, so blinkt der Ring 44. Durch diese Signalisierung können von einer Bedienperson dynamische Lastspitzen erkannt werden.

Die beschriebenen Drehmomentsensoren können auch an einer Kupplung anstelle, einer Welle angeordnet sein. Des Weiteren können sie zum Ermitteln eines Drehmoments eingesetzt werden, welches über eine Welle zu einem Generator übertragen wird.

Durch die Beispiele ist gezeigt, wie durch die flächige und durchgehende Beschichtung einer Hülse oder eines Rings, die jeweils aus einem flexiblen Material bestehen können, eine konstruktiv vorteilhafte Messung des Drehmoments ermöglicht ist. Durch den Leuchteffekt können zusätzlich die Drehmomente auf der Welle visualisiert werden.

## Patentansprüche

1. Vorrichtung (20, 42) zum Ermitteln eines auf eine Antriebswelle (14) wirkendes Drehmoments, umfassend:
- eine mit der Antriebswelle (14) oder einer Kupplung derselben fest verbundene Felderzeugungseinrichtung (14), welche in einer Umgebung der Antriebswelle (14) ein magnetisches Feld erzeugt, das von dem Drehmoment abhängig ist,
**gekennzeichnet durch**
- ein organisches, magnetoresistives OMR-Halbleiterelement (22'), welches ortsfest in der Umgebung angeordnet ist, wobei durch das OMR-Halbleiterelement (22') eine OLED (22') gebildet ist, und
- eine Spannungsquelle (28) zum Erzeugen einer elektrischen Spannung zwischen zwei Elektroden (24, 26) des OMR-Halbleiterelements (22').

2. Vorrichtung (20, 42) nach Aspruch 1, bei welcher das OMR-Halbleiterelement (22') als Schicht ausgebildet ist, welche die Antriebswelle (14) und/oder die Kupplung zumindest bereichsweise umgibt, wobei sie bevorzugt die Form eines Hohlzylinders (22, 44, 46, 48) oder eines Segments davon aufweist.

3. Vorrichtung (20, 42) nach Anspruch 1 oder 2, bei welcher das OMR-Halbleiterelement (22') auf einem flexiblen Substrat angeordnet ist.

4. Vorrichtung (20, 42) nach einem der vorhergehenden Ansprüche, welche eine Messeinrichtung (32 bis 38) zum Messen einer Größe (Um) aufweist, die zu einem durch das OMR-Halbleiterelement fließenden Strom (I) und/oder einer an dem OMR-Halbleiterelement anliegenden Spannung (U) proportional ist.

5. Vorrichtung (20, 42) nach einem der vorhergehenden Ansprüche, bei welcher die Spannungsquelle (28) als Konstantspannungsquelle ausgelegt ist.

6. Vorrichtung (20, 42) nach einem der vorhergehenden Ansprüche, wobei die elektrische Spannung (U) auf einen Wert (U0) eingestellt ist, bei welchem die OLED (22') nur leuchtet, falls das Drehmoment ein vorbestimmtes Kriterium erfüllt.

7. Vorrichtung (42) nach einem der vorhergehenden Ansprüche, welche insgesamt wenigstens zwei OMR-Halbleiterelemente (44, 46, 48) der genannten Art aufweist, die unterschiedliche, ihre magneto-resistive Eigenschaft beschreibende Kennlinien aufweisen und/oder an deren Elektroden die Spannungsquelle in einem Betrieb der Vorrichtung unterschiedlich große Spannungen erzeugt.

8. Vorrichtung (42) nach einem der vorhergehenden Ansprüche, welche insgesamt wenigstens zwei OMR-Halbleiterlemente (44, 46, 48) aufweist, welche jeweils eine OLED (44, 46, 48) bilden, wobei die OLEDs (44, 46, 48) in Bezug auf das Drehmoment unterschiedliche Leuchtgrenzen aufweisen.

9. Vorrichtung (20, 42) nach einem der vorhergehenden Ansprüche, bei welcher die Felderzeugungseinrichtung (14) ein Element umfasst, welches das magnetische Feld durch inverse Magnetostriktion in Abhängigkeit von einer durch das Drehmoment bewirkten Veränderung seiner Form erzeugt.

10. Verfahren zum Ermitteln eines über eine Antriebswelle (14) übertragenen Drehmoments (16, 18),
- auf der Antriebswelle (14) oder auf einer Kupplung derselben Erzeugen eines magnetischen Felds in Abhängigkeit von dem Drehmoment (16, 18);
- Erfassen des magnetischen Felds in einer Umgebung der Antriebswelle (14) mittels eines magnetoresistiven Halbleiterelements (22');
- Einstellen einer elektrischen Größe (Um) in Abhängigkeit von dem erfassten magnetischen Feld mittels des Halbleiterelements (22'),
**dadurch gekennzeichnet, dass**
als das magnetoresistive Halbleiterelement (22') ein organisches, magnetoresistives Halbleiterelement (22') verwendet wird, durch welches eine OLED (22') gebildet ist, und mittels der OLED (22') das von der Welle übertragene Drehmoment visuell dargestellt wird.

## Claims

1. Device (20, 42) for determining a torque acting on a drive shaft (14), comprising:
- a field generating device (14) which is firmly connected to the drive shaft (14) or a coupling of the same and which, in the surroundings of the drive shaft (14), generates a magnetic field that depends on the torque,
**characterized by**
- an organic magnetoresistive OMR semiconductor element (22'), which is arranged in a stationary manner in the surroundings, wherein the OMR semiconductor element (22') forms an OLED (22'), and
- a voltage source (28) for generating an electric voltage between two electrodes (24, 26) of the OMR semiconductor element (22').

2. Device (20, 42) according to Claim 1, in which the OMR semiconductor element (22') is formed as a layer which surrounds the drive shaft (14) and/or the coupling, at least in some regions, wherein it preferably has the shape of a hollow cylinder (22, 44, 46, 48) or of a segment thereof.

3. Device (20, 42) according to Claim 1 or 2, in which the OMR semiconductor element (22') is arranged on a flexible substrate.

4. Device (20, 42) according to one of the preceding claims, which has a measuring device (32 to 38) for measuring a variable (Um) which is proportional to a current (I) flowing through the OMR semiconductor element and/or a voltage (U) present on the OMR semiconductor element.

5. Device (20, 42) according to one of the preceding claims, in which the voltage source (28) is designed as a constant-voltage source.

6. Device (20, 42) according to one of the preceding claims, wherein the electric voltage (U) is preferably set to a value (U0) at which the OLED (22') illuminates only if the torque satisfies a predetermined criterion.

7. Device (42) according to one of the preceding claims, which has a total of at least two OMR semiconductor elements (44, 46, 48) of the stated type, which have different characteristic curves describing their magnetoresistive property, and/or on the electrodes of which the voltage source generates voltages of different magnitudes during operation of the device.

8. Device (42) according to one of the preceding claims, which has a total of at least two OMR semiconductor elements (44, 46, 48), which each form an OLED (44, 46, 48), wherein the OLEDs (44, 46, 48) have different illumination limits in relation to the torque.

9. Device (20, 42) according to one of the preceding claims, in which the field generating device (14) comprises an element which generates the magnetic field by means of inverse magnetostriction as a function of a change in its shape which is caused by the torque.

10. Method for determining a torque (16, 18) transmitted via a drive shaft (14),
- generating a magnetic field on the drive shaft (14) or on a coupling of the same as a function of the torque (16, 18);
- detecting the magnetic field in the surroundings of the drive shaft (14) by means of a magnetoresistive semiconductor element (22');
- setting an electric variable (Um) as a function of the detected magnetic field by means of the semiconductor element (22'),
**characterized in that** the magnetoresistive semiconductor element (22') used is an organic magnetoresistive semiconductor element (22'), by means of which an OLED (22') is formed, and, by means of the OLED (22'), the torque transmitted by the shaft is displayed visually.

## Revendications

1. Dispositif (20, 42) pour déterminer un couple agissant sur un arbre d'entraînement (14), comprenant :
- un appareil (14) de production de champ relié fixe à l'arbre d'entraînement (14) ou à un couplage de celui-ci, qui produit un champ magnétique dépendant dudit couple dans un environnement de l'arbre d'entraînement (14)
**caractérisé par**
- un élément semi-conducteur magnétorésistif organique OMR (22'), qui est agencé stationnaire dans l'environnement, une OLED (22') étant formée grâce à l'élément semi-conducteur OMR (22'), et
- une source de tension (28) pour produire une tension électrique entre des électrodes (24, 26) de l'élément semi-conducteur OMR (22').

2. Dispositif (20, 42) selon la revendication 1, dans lequel l'élément semi-conducteur OMR (22') est réalisé sous la forme d'une couche qui entoure au moins par secteurs l'arbre d'entraînement (14) et/ou le couplage, ladite couche présentant de manière préférée la forme d'un cylindre creux (22, 44, 46, 48) ou d'un segment de celui-ci.

3. Dispositif (20, 42) selon la revendication 1 ou 2, dans lequel l'élément semi-conducteur OMR (22') est agencé sur un substrat flexible.

4. Dispositif (20, 42) selon l'une quelconque des revendications précédentes, qui présente un appareil de mesure (32 à 38) pour une mesure d'une grandeur (Um) qui est proportionnelle à un courant (I) circulant à travers l'élément semi-conducteur OMR et/ou à une tension (U) existant au niveau de l'élément semi-conducteur OMR.

5. Appareil (20, 42) selon l'une quelconque des revendications précédentes, dans lequel la source de tension (28) est conçue en tant que source de tension constante.

6. Dispositif (20, 42) selon l'une quelconque des revendications précédentes, dans lequel la tension électrique (U) est réglée sur une valeur (UO) pour laquelle l'OLED (22') ne s'illumine que lorsque le couple satisfait un critère prédéterminé.

7. Dispositif (42) selon l'une quelconque des revendications précédentes, qui présente au total au moins deux éléments semi-conducteurs OMR (44, 46, 48) du type évoqué, qui présentent des caractéristiques différentes décrivant leur propriété magnétorésistive et/ou au niveau des électrodes desquels la source de tension produit des tensions de différentes valeurs lors d'un fonctionnement du dispositif.

8. Dispositif (42) selon l'une quelconque des revendications précédentes, qui présente au total au moins deux éléments semi-conducteurs OMR (44, 46, 48) qui forment respectivement une OLED (44, 46, 48), les OLED (44, 46, 48) présentant des limites d'éclairement différentes en fonction du couple.

9. Dispositif (20, 42) selon l'une quelconque des revendications précédentes, dans lequel l'appareil (14) de production de champ comprend un élément qui produit le champ magnétique grâce à une magnétostriction inverse en fonction d'une modification de sa forme provoquée par le couple.

10. Dispositif pour déterminer un couple (16, 18) transmis par l'intermédiaire d'un arbre d'entraînement (14),
- sur l'arbre d'entraînement (14) ou sur un couplage de celui-ci, produire un champ magnétique en fonction du couple (16, 18) ;
- enregistrer le champ magnétique dans un environnement de l'arbre d'entraînement (14) au moyen d'un élément semi-conducteur magnétorésistif (22') ;
- régler une grandeur électrique (Um) en fonction du champ magnétique enregistré au moyen de l'élément semi-conducteur (22'),
**caractérisé en ce que**,
un élément semi-conducteur magnétorésistif (22') organique, grâce auquel une OLED (22') est formée, est utilisé en tant qu'élément semi-conducteur magnétorésistif (22'), et le couple transmis par l'arbre est représenté de manière visuelle au moyen de l'OLED (22').
